# EUROPEAN PATENT SPECIFICATION

(11) **EP 3 655 790 B1**
(45) Date of publication and mention of the grant of the patent: **05.05.2021**
(21) Application number: 17761792.5
(22) Date of filing: 29.08.2017
(51) Int. Cl.: G01R 33/34, G01R 33/36

(54) **TUNABLE NMR COIL AND PROBE HEAD CONTAINING THE NMR COIL**
ABSTIMMBARE NMR-SPULE UND SONDENKOPF MIT EINER DERARTIGEN SPULE
BOBINE RMN ACCORDABLE ET TÊTE DE SONDE CONTENANT UNE TELLE BOBINE

(43) Date of publication of application: 27.05.2020
(73) Proprietor: Qonetec AG, 8305 Dietlikon (CH)
(72) Inventor: STAUFFENEGGER, Philippe, 8600 Dübendorf (CH)
(74) Representative: Sutter, Kurt
(86) International application number: PCT/CH2017/000079
(87) International publication number: WO 2019/041053

(56) References cited:
- EP-A2- 1 898 228
- US-A- 4 694 255
- US-A1- 2004 189 304
- Joël Mispelter ET AL: "Tuning the birdcage resonator" In: "NMR Probeheads for Biophysical and Biomedical Experiments", 2006, London, XP055469321, pages 386-399, the whole document
- GURLER N. ET AL.: "A New Accurate FEM Based Optimization Method for Birdcage Coil Design at High Field Strength", PROCEEDINGS OF THE INTERNATIONAL SOCIETY FOR MAGNETIC RESONANCE IN MEDICINE, 21ST ANNUAL MEETING, 21ST ANNUAL MEETING, 7 April 2013 (2013-04-07), page 2807, XP040630403, Utah, USA
- JEONG E.K. ET AL.: "A Simple Inductive Tuning of Birdcage Coil, with Wide Range of Tuning", PROCEEDINGS OF THE INTERNATIONAL SOCIETY FOR MAGNETIC RESONANCE IN MEDICINE, FIFTH SCIENTIFIC MEETING AND EXHIBITION, 12 April 1997 (1997-04-12), XP040658227, Canada

## Description

### Technical Field

The invention relates to an NMR coil and an NMR probe head comprising such a coil.

The invention also relates to a method for reducing the asymmetry in such an NMR probe head or NMR coil.

In this context, the term NMR is used to encompass both Nuclear Magnetic Resonance as well as Magnetic Resonance Imaging (MRI) and MAS (Magic-Angle-Spinning) solid-state NMR applications.

### Background Art

In NMR probing, a sample is placed in a strong, static magnetic field. A coil arranged around the sample is then used to generate a dynamic magnetic field perpendicular to the static magnetic field, which causes nuclear spins in the sample to precess about the static field. This precession can be recorded by the coil.

An advantageous type of coil is the so-called birdcage coil or birdcage resonator, which allows to generate as well as to record magnetic fields in two dimensions perpendicular to the static field (Quadrature Mode).

Birdcage coils are widely used in MRI, but they have also been proposed for other NMR applications.

A birdcage coil typically comprises a first and a second conductive ring and a plurality of mutually spaced apart connectors extending between the two rings. The connectors are e.g. formed by bars.

The coil must be tuned to be in resonance with the Larmor frequency of the nucleus to be scanned. Hence, it has been proposed to provide tunable birdcage coils. US 4694255 describes one such tunable birdcage coil where each connector comprises a reactance element. The reactance elements are commonly tunable in order to tune the resonance frequency of the coil.

A birdcage with two tunable capacitors is described in Joël Mispelter et al., "Tuning the birdcage resonator", published in "NMR Probeheads for Biophysical and Biomedical Experiments", year 2006, London, pp. 386 - 399.

### Disclosure of the Invention

The problem to be solved by the present invention is to provide an NMR coil and a probe head that have improved sensitivity and that can be tuned easily.

This problem is solved by the coil according to claim 1 and the NMR probe head according to claim 16.

Accordingly, the NMR coil comprises:
- A first and a second conductive ring: These rings are arranged at a distance from each other.
- A plurality of mutually spaced apart connectors extending between said first and second conductive rings: The rings and the connectors together form a birdcage coil. The connectors are typically formed by individual bars extending between the first and second ring, but they may also be formed by conducting elements arranged on a common carrier.

Further, each of at least several of said connectors comprises at least one "reactance element". In other words, more than one of the connectors comprises at least one reactance element. In this context, a reactance element is an element having non-zero inductance and/or capacitance. In many embodiments, each connector has a reactance element. In other embodiments, though, only part of the connectors may comprise reactance elements.

At least one of the reactance elements is a "tunable reactance element", i.e. its capacity or inductance is tunable. Typically, each connector comprises at least one tunable reactance element, even though it is also possible to have tunable reactance elements only in part of the connectors, e.g. in every other connector, in order to reduce device complexity.

Finally, the at least one tunable reactance element is tunable independently of the reactance of at least one other reactance element. In other words, the reactance of at least one of the connectors can be tuned independently of the reactance of at least one other connector.

This design allows tuning the symmetry of the birdcage coil. The invention is based on the understanding that birdcage coil resonators often lack perfect symmetry, which leads to a loss of sensitivity, e.g. due to a broadening and splitting of the birdcage's resonances. Asymmetries can e.g. be caused by imperfect birdcage geometries, coupling to lossy samples and/or other NMR coils, or asymmetries caused by the components surrounding the birdcage resonator.

Advantageously, the coil comprises several tunable reactance elements. This allows compensating more complex asymmetries.

In another advantageous embodiment, each connecting element comprises at least one tunable reactance element, which allows tuning the resonance frequency and/or impedance of the coil as a whole. If all these tunable reactance elements are tunable independently from each other, a large variety of asymmetries can be corrected.

The reactance element comprises a capacitive element having at least the following parts:
- A first electrode: This first electrode is electrically connected to the first conductive ring. The connection to the ring can be a direct connection or an indirect one, in the latter case being formed by one or more of a resistor, an inductance and/or a capacitance.
- A second electrode: This second electrode is electrically connected to the second conductive ring. The connection to the ring can again be a direct connection or an indirect one, in the latter case being formed by one or more of a resistor, an inductance and/or a capacitance.

The capacitive element further comprises a third electrode electrically insulated from and capacitively connected to the first and the second electrodes. Such a design can be used to increase the capacitance between the first and second electrodes.

The third electrode is movable in respect to the first and second electrodes. Moving the third electrode changes the capacitance between the first and second electrodes, thereby providing for a tunable capacitive element.

Each of said connectors comprises an insulating rod and at least one electrically conductive layer arranged on or in the rod, wherein said first and second electrodes are interdigital electrodes formed by said conductive layer. In this case, the rod provides the mechanical stability while the conductive layer establishes the electrical connection between the rings.

The conductive layer can e.g. be arranged on a surface of the rod.

Advantageously, the rod is of a ceramic material. Such materials can be machined with high accuracy and allow building coils with good symmetry.

In order to reduce the resistive losses in the coil, the rod can be shaped to have a cylindrical surface and, at least over part of the length of the rod, the conductive layer extends all around a circumference of said cylindrical surface. This leads to a homogenous RF current distribution within the conductive layer, which reduces the resistance as compared to designs where the conductive layer has edges or corners.

In order to implement a capacitor element as described above, the insulating rod can comprise a cavity, in particular a cavity extending along a whole length of the rod. The first and second electrodes are formed by sections of the conductive layer while the third electrode is arranged in the cavity.

Advantageously, the third electrode is movable in the cavity for tuning the capacity.

The conductive layer can also be structured to form at least one coil inductor and/or at least one meander inductor. This can e.g. be used to adapt the resonance frequency of the birdcage resonator and/or to build filters into the birdcage resonator.

A gap structure can be arranged in the conductive layer, i.e. non-conductive gaps can be formed therein, in order to change the inductance of the connector and/or to form capacitances therein. This gap structure can advantageously differ between at least two of the connectors. Such different gap structures can be used for permanently tuning the symmetry of the coil.

The invention also relates to An NMR probe nead comprising
- A coil as mentioned above: In operation, this probe holds the sample and is placed in a magnet generating the stationary magnetic field.
- A base having a housing and an electrical interface: In operation, the base is typically located outside the magnet.
- A tube extending between the housing and the coil: This tube provides the mechanical connection between the base and the coil. For example, the base is located at one end of the tube while the coil is located in the other end of the tube. The tube can also receive the electrical leads between the base and the coil.

Advantageously, the NMR probe head comprises an actuator mechanically connected to the tunable reactance. The actuator can be adapted and structured to tune the tunable reactance.

In order to tune several reactances separately, the NMR probe head comprises several of the tunable reactance elements and several of the actuators, with each actuator being connected to one tunable reactance element.

The invention also relates to a method for reducing the asymmetry in the NMR probe head or the NMR coil above. This method comprises comprising the steps of detecting an asymmetry of the coil, and
adjusting the at least one tunable reactance to reduce the asymmetry.

### Brief Description of the Drawings

The invention will be better understood and objects other than those set forth above will become apparent when consideration is given to the following detailed description thereof. This description makes reference to the annexed drawings, wherein:
Fig. 1 shows an embodiment of an NMR probe head,
Fig. 2 is a block circuit diagram of an embodiment of an NMR coil,
Fig. 3 is a circuit diagram of an NMR coil,
Fig. 4 shows an embodiment of an NMR coil,
Fig. 5 shows a single rod of the NMR coil of Fig. 4,
Fig. 6 is a sectional view of the rod of Fig. 5 along its axis,
Fig. 7 is a sectional view along line VII-VII of Fig. 6,
Fig. 8 shows a first embodiment of an inductive element,
Fig. 9 shows a second embodiment of an inductive element,
Fig. 10 shows the gap structure of the second embodiment of the inductive element as unwound from the cylindrical rod surface, and
Fig. 11 shows an NMR coil with static tuning.

### Modes for Carrying Out the Invention

NMR probe head:

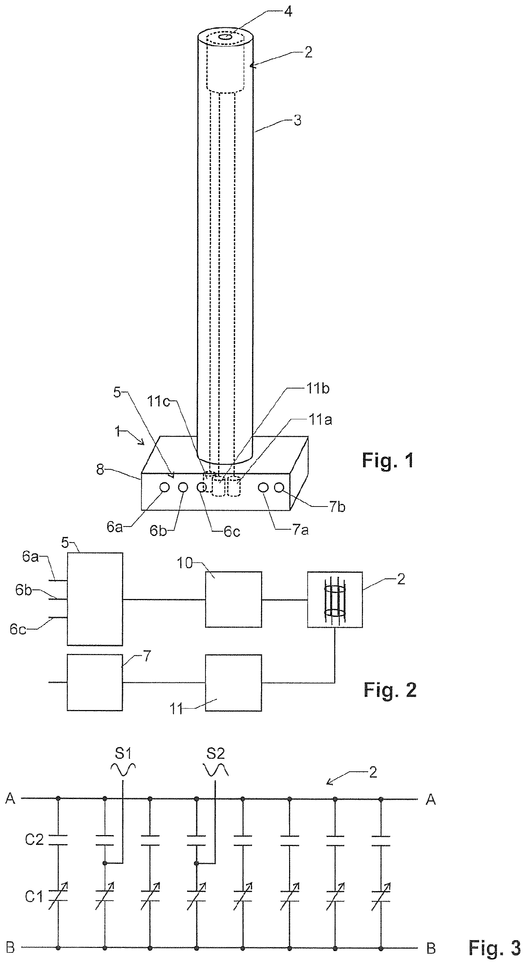

Fig. 1 shows an embodiment of a NMR probe head. It comprises a base 1, a coil 2, and a tube 3 extending between base 1 and coil 2.

It further comprises a holder 4 for receiving a sample, in particular a liquid sample in a sample tube. Holder 4 is positioned to hold the sample in coil 2.

In operation, tube 3 is inserted into a magnet, in particular a superconducting magnet, to place coil 2 into a homogeneous section of a static magnetic field. In this position, base 1 remains accessible outside the magnet.

Base 1 comprises an electrical interface 5 for connecting coil 2 and other components of the NMR probe head to external circuitry. In one example, base 1 may comprise connectors 6a, 6b, 6c for carrying out measurements at standardized 1H, 2H and 13C frequencies.

Base 1 may further comprise connectors 7a, 7b for controlling actuators 11 within the NMR probe head as will be described in more detail below.

Base 1 has typically a housing 8, which can e.g. be box-shaped or cylindrical. Tube 3 is advantageously cylindrical and has a smaller diameter than base 1 in order to fit into a central opening of the magnet.

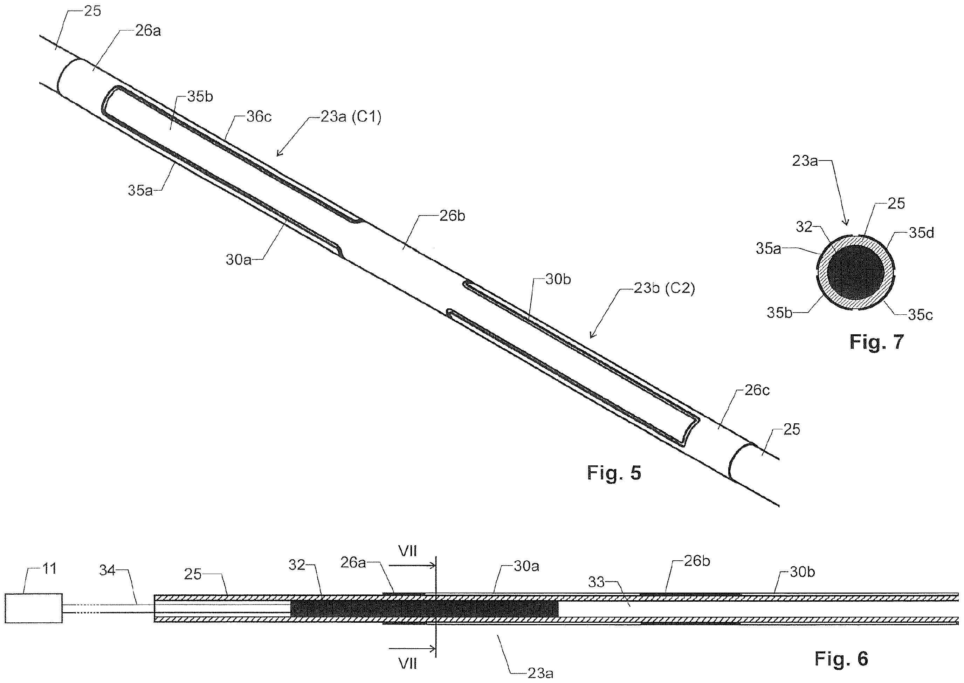

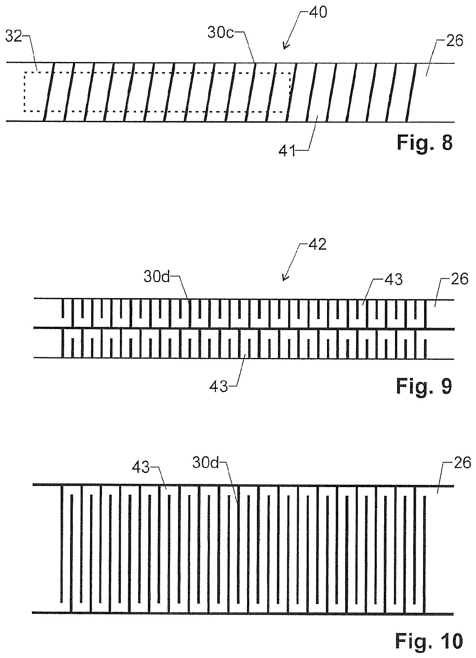

Fig. 2 shows a block circuit diagram of the NMR probe head. As can be seen, electrical interface 5 is connected to an RF circuit 10, which matches the signals to coil 2 and has tuning capabilities depending on the frequency to be used in the measurement. This type of circuit is known to the skilled person, see e.g. Fig. 9 of US 6876200 or Fig. 5 of US 2008/0117560.

The NMR probe head further comprises, as mentioned, a number of actuators 11 that are able to actuate mechanical elements in coil 2 and/or RF circuit 10. This will be described in more detail below.

In the embodiment of Fig. 1, three such actuators 11a, 11b, 11c are shown. In many cases, there may be eight or more such actuators.

NMR coil:

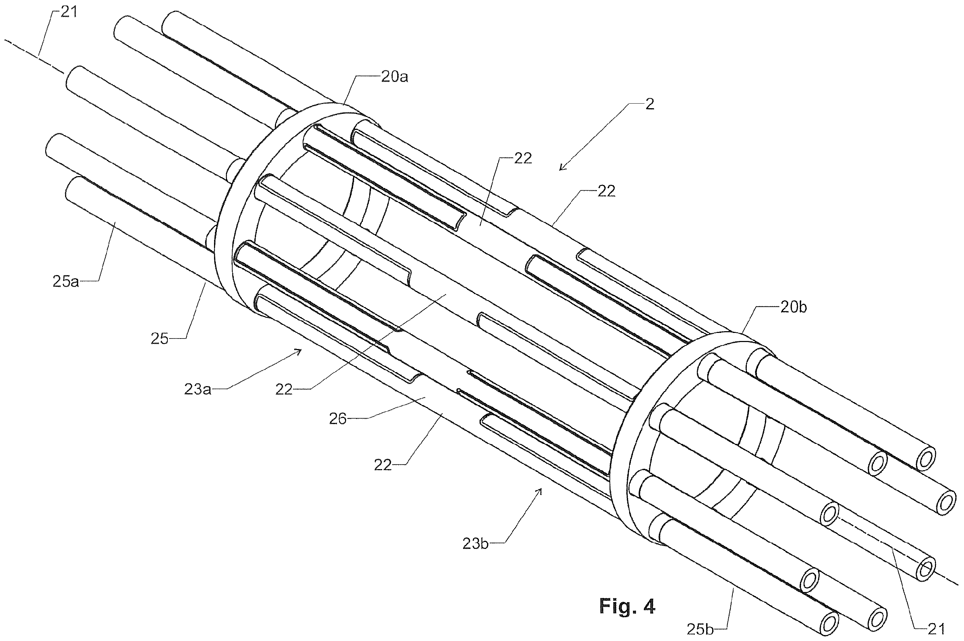

Fig. 4 shows an embodiment of a coil 2 and Fig. 3 its equivalent circuit diagram.

As can best be seen from Fig. 4, coil 2 comprises a first ring 20a and a second ring 20b. Each ring is RF conductive. It may be formed, as shown, by a body of conductive material, or it may comprise sections of conductors interconnected by capacitors.

The rings 20a, 20b are advantageously annular (i.e. circular).

In the shown embodiment, the rings 20a, 20b are coaxial to a coil axis 21, parallel, and arranged at a distance from each other.

In order to keep magnetic field distortions at a minimum, the rings 20a, 20b are advantageously of a material having zero magnetic susceptibility, such as an alloy of copper (which is diamagnetic) and rhodium (which is paramagnetic).

A plurality of mutually spaced-apart connectors 22 extend between the two rings 20a, 20b. Advantageously, they are arranged equidistantially.

In the embodiment shown, the connectors 22 extend parallel to coil axis 21 and perpendicular to the planes of the rings 20a, 20b. Alternatively, an angled design, such as known from US 6420871, can be used as well.

The space between the rings 20a, 20b and the connectors 22 forms the sample space where the sample is located during the measurement.

As described in more detail below, several or all of the connectors 22 have a reactance element 23a, 23b. In the embodiment shown in Fig. 4, each connector 22 has two such reactance elements 23a, 23b.

At least one of the reactance elements 23a, 23b is tunable. In the embodiment of Fig. 4, each connector 22 has at least one tunable reactance element 23a.

In the shown embodiment, the reactance elements 23a, 23b are capacitive elements, i.e. they form capacitors.

Each connector 22 of the embodiment of Fig. 4 comprises an insulating rod 25 with an electrically conductive layer 26 arranged on at least part thereof.

As mentioned above, insulating rod 25 is advantageously of a ceramic material. A suitable material comprises aluminum oxide for its low losses at the frequencies typically used in NMR measurements. Advantageously, the insulating rods 25 comprise at least 96 weight-percent of aluminum oxide.

Since, in the embodiment shown, the insulating material used in the rods 25 does not have zero magnetic susceptibility, i.e. it has a tendency to distort the static magnetic field around it. This distortion is strongest at the ends of the rods 25, for which reason each rod 25 has end sections 25a, 25b extending beyond the rings 20a, 20b, thereby keeping the field distortions away from the sample.

In another embodiment, insulating rod 25 may consist of a material having zero susceptibility, such as aluminum oxide with chrome, in which case the end sections 25a, 25b can be dispensed with.

The conductive layer 26 applied to the insulating rods 25 advantageously has zero magnetic susceptibility, e.g. by using a combination of para- and diamagnetic materials, such as chrome and copper, mixed in an alloy or applied as different layers. For example, it may comprise a first layer of chrome and a second layer of copper. For passivating its surface, a third layer of gold may be added.

As mentioned, in the embodiment of Fig. 4, the reactance elements 23a, 23b are capacitive elements, i.e. they form two capacitors C1, C2 on each connector 22. Fig. 3 shows an equivalent circuit diagram 3 (which, for simplicity, omits the inductances formed by the conductive leads of the rings 20a, 20b and on the connectors 22) .

If tuned symmetrically, the network of Fig. 3 has RF resonances where a magnetic field pointing into a direction perpendicular to coil axis 21 rotates about coil axis 21. Such resonances are used in birdcage resonators for carrying out quadrature-based measurements.

These resonances can e.g. be excited (or measured) by applying (or detecting) two 90° phase shifted signals S1, S2 at connectors that are azimuthally spaced by 90°, as it is shown in Fig. 3.

As it can also be seen in Fig. 3, at least the capacitors C1 are tunable capacitors or, more generally, tunable reactance elements. They can be used to tune the coil as described below.

Possible embodiments of reactance elements are described in the next section.

Reactance elements:
In the embodiment of Fig. 4, each reactance element 23a, 23b is a capacitor. Its design is best understood from Figs. 5 - 7, which show a single connector 22.

As can be seen, conductive layer 26 comprises three sections 26a, 26b, 26c, which are separated from each other by two gaps 30a, 30b. The gaps 30a, 30b are in the following, generally denoted by the term "gap structure".

First section 26a is electrically connected to the first ring 20a and third section 26c is electrically connected to the second ring 20b. The second (middle section) 26b is arranged between the first and third sections 26a, 26b.

The neighboring sections 26a, 26b are part of a first capacitor C1 or reactance element 23a while the neighboring sections 26b, 26c are part of a second capacitor C2 or reactance element 23b.

In the embodiment shown, first reactance element 23a is a tunable capacitor. It comprises a first stationary electrode formed by first section 26a, a second stationary electrode formed by second section 26b, as well as a movable electrode 32.

Movable electrode 32 is slideably arranged in a cavity 33 of rod 25 (see Figs. 6, 7). In the embodiment shown, cavity 33 extends all the way through the length of rod 25, i.e. rod 25 is a tube. Alternatively, cavity 33 may e.g. extend only from one end of rod 25 to the location of the tunable capacitor.

Movable electrode 32 is electrically insulated from the first and second sections 26a, 26b by the wall of cavity 33, i.e. by the material of rod 25. However, it can be positioned to overlap the electrodes or sections 26a, 26b in axial direction, where it capacitively couples to both of them. Therefore, depending on its axial position, movable electrode 32 will affect the capacitance of the tunable capacitor C1.

Movable electrode 32 is advantageously formed of a material having zero susceptibility, such as an alloy of copper and rhodium.

Movable electrode 32 is connected, via an actuator rod 34, to one of the actuators 11 of the NMR probe head.

Actuator 11 can e.g. by a piezoelectric actuator, such as it is e.g. described in US 2008/0117560.

The second capacitor C2 or reactance element 23b comprises second section 26a and third section 26c. In the embodiment shown, this second capacitor C2 is not tunable and lacks a movable electrode. At its location, there may be no electrode in cavity 34, or there may be such an electrode but located at a fixed position and not connected to an actuator.

In order to increase the capacitance of first and/or second capacitor C1, C2, its stationary electrodes 26a, 26b (for C1) or 26b, 26c (for C2) may be interdigital electrodes with fingers 35a, 35b, 35c, 35d, as it can best be seen in Figs. 5 and 7, i.e. the gap between the electrodes extends along a meandering path.

In another embodiment, the reactance elements may also comprise and/or consist of inductors.

For example, and as shown in Fig. 8, the reactance element comprises a coil inductor 40, where the gap structure in conductive layer 26 comprises a section 30c extending around rod 25 along a helical path, thereby forming a helical, conductive lead 41 of conductive layer 26.

As shown in dotted lines, a movable electrode 32 can again be arranged within rod 25. It capacitively couples to the coil and affects its total inductance as well as capacitance.

In another embodiment, and as shown in Figs. 9 and 10, the reactance element comprises a meander inductor 42, where the gap structure in conductive layer 26 comprises a section 30c forming a meandering, conductive lead 43 of conductive layer 26.

This embodiment may again be combined with a movable electrode 32, as the one shown in Fig. 8.

Tuning:
According to the present invention, at least one of the reactance elements in the coil is tunable. This can be used for a number of different goals.

In one embodiment, since the tunable reactance element is tunable independently of the reactance of at least one other reactance element, the technique can be used to correct for asymmetries in the coil. Such asymmetries can e.g. arise from a non-perfect geometrical configuration of the coil, from non-symmetric properties or a non-symmetric placement of the sample, or from asymmetric parts of the equipment close to coil 2, or from the coupling with other coils. With the present setup, it is possible to tune also this type of coupling, in particular to minimize it.

The correction of such asymmetries typically comprises the following steps:
(1) Detecting an asymmetry of the coil, e.g. by means of an isolation measurement between mode 1 and mode 2 (e.g. measuring the S-parameter S21 with a Vector Network Analyzer (VNA)).
(2) Adjusting at least one tunable reactance to reduce this asymmetry.

These steps can optionally be repeated in order to further reduce the asymmetry. The isolation between the two modes should advantageously be better than 40 - 50 dB. For details, see e.g. Chen, Hoult, Sank, JMR 54, 324 - 327 (1983). Further, the quality factor and ball shift (= measure for B1-sensitivity) of both modes should be maximal and equal.

The number of tunable reactance elements that are required depends on the asymmetry to be compensated and the desired accuracy of the compensation. In some examples, a single tunable reactance element may suffice. In others, however, it may be necessary to provide all or all but one connector 22 with a tunable reactance element.

In another embodiment, the tunable reactance elements can be used for tuning the resonance frequency of the whole coil, for tuning the impedance of the coil, or for tuning blocking filters integrated into the coil. In these cases, all connectors 22 advantageously comprise at least one tunable reactance element.

Static Factory-Side Tuning (Trimming):
In the embodiments above, it has been described how dynamically tunable reactance elements can be provided in coil 2 for dynamically compensating asymmetries.

A similar technique, though, can also be used to statically tune the coil, i.e. to compensate asymmetries that do not change over time, e.g. asymmetries due to imperfections during its manufacturing process.

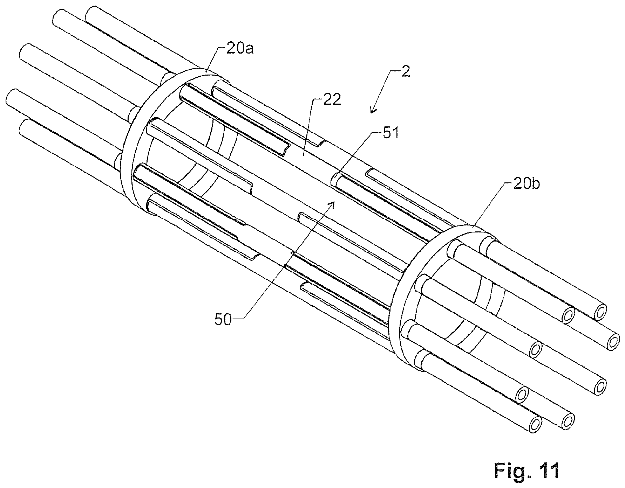

For example, measurements on the finished coil may show that the capacitance of one of the capacitors in one of the connectors, e.g. the one at reference number 50 of Fig. 11, is too high. In that case, the respective width of the gap 30 between its electrodes can be widened, e.g. by using laser ablation. Such a widened gap is shown, by way of example, at reference number 51.

This technique can be used to widen any part of the gap structure in conductive layer 26, which leads to a coil where the gap structures differ between at least two of the connectors 22.

Static tuning can also be applied in combination with inductive elements, such as shown in Figs. 8 and 9, where the length of the coil or meander can e.g. be increased by cutting longer gaps into conductive layer 25.

Notes:
In the above embodiments, conductive layer 26 is arranged on a cylindrical surface of rod 25. For the reasons explained above, this design decreases the overall losses of the resonator. Alternatively, though, the connectors between the rings 20a, 20b may also be arranged on a common carrier, such as an insulating tube, e.g. as shown in US 6420871.

In the shown embodiments, conductive layer 26 is arranged on the outer surface of rod 25. However, part or all of it may also be arranged on its inner surface, i.e. on the surface of cavity 33. Part or all of conductive layer 26 may also be embedded within rod 25 if rod 25 is a multilayer structure.

In the embodiments above, there are eight connectors 22 connecting the rings 20a, 20b. It must be noted that this number can be varied. In order to carry out quadrature-based measurements, a fourfold symmetry is advantageous.

In the embodiment of Figs. 3 and 4, each connector 22 comprises two capacitive reactance elements arranged in series. However, coil 2 can e.g. also comprise only a single reactance element per connector 22, in particular for lower resonant frequencies.

Tunable reactance elements can be located in every connector 22, or in only a subset of the connectors.

The capacitors in Figs. 4 - 7 are implemented using interdigital electrodes. In another embodiment, the capacitors may also be formed between the adjacent, blunt ends of two cylindrical sleeve-shaped (i.e. cylindrical) conductive layer sections. To increase the capacitance of such a capacitor, a third electrode 32 overlapping both conductive layer sections, can provided in cavity 33.

While there are shown and described presently preferred embodiments of the invention, it is to be distinctly understood that the invention is not limited thereto but may be otherwise variously embodied and practiced within the scope of the following claims.

## Claims

1. An NMR coil comprising
a first and a second conductive ring (20a, 20b) arranged at a distance from each other,
a plurality of mutually spaced apart connectors (22) extending between said first and second conductive rings (20a, 20b), wherein each of at least several of said connectors (22) comprises at least one reactance element (23a, 23b, 40, 42),
wherein at least one of said reactance elements (23a, 23b, 40, 42) is a tunable reactance element (23a) with a reactance tunable independently of a reactance of at least one other reactance element (23a, 23b, 40, 42), and
wherein at least part of said reactance elements (23a, 23b) comprises a capacitive element having
a first electrode (26a, 26b) electrically connected to the first conductive ring (20a) and
a second electrode (26b, 26c) electrically connected to the second conductive ring (20b) and electrically insulated from said first electrode (26a, 26b),
**characterized in that**
each of said connectors (22) comprises an insulating rod (25) and at least one electrically conductive layer (26) arranged on or in said rod (25), wherein said first and second electrodes (23a, 23b, 23c) are interdigital electrodes (35a - 35d) formed by said conductive layer (26), and
wherein said capacitive element (23a) comprises, in addition to said first electrode (26a) and said second electrode (26b), a third electrode (32) electrically insulated from said first and said second electrodes (26a, 26b), wherein said third electrode (32) is movable in respect to said first and second electrodes (26a, 26b).

2. The NMR coil of claim 1 comprising several independently tunable reactance elements (23a).

3. The NMR coil of any of the preceding claims, wherein each connector (22) comprises at least one tunable reactance element (23a).

4. The NMR coil of claim 3 wherein said tunable reactance elements (23a) are tunable independently from each other.

5. The NMR coil of any of the preceding claims wherein said electrodes (26a, 26b, 26c) have zero magnetic susceptibility.

6. The NMR coil of any of the preceding claims wherein the at least one electrically conductive layer (26) is arranged on a surface of said rod (25).

7. The NMR coil of any of the preceding claims wherein said rod (25) is of a ceramic material, and in particular of a ceramic material comprising aluminum oxide.

8. The NMR coil of any of the preceding claims wherein said conductive layer (26) has zero magnetic susceptibility, and in particular wherein said conductive layer (26) comprises rhodium and copper.

9. The NMR coil of any of the preceding claims wherein said rod (25) has a cylindrical surface and wherein, at least over part of a length of said rod (25), said conductive layer (26) extends all around a circumference of said cylindrical surface.

10. The NMR coil of any of the preceding claims wherein said first and second electrodes (26a, 26b, 26c) are formed by sections of said conductive layer (26) .

11. The NMR coil of claim 10 wherein said rod (25) comprises a cavity (33) and wherein said third electrode (32) is arranged in said cavity (33).

12. The NMR coil of claim 11 wherein said third electrode (32) is movably arranged in said cavity (33) .

13. The NMR coil of any of the claims 11 or 12 wherein said cavity (33) extends along a whole length of said rod (25).

14. The NMR coil of any of the preceding claims wherein said conductive layer (26) forms at least one coil inductor (40) and/or at least one meander inductor (42).

15. The NMR coil of any of the preceding claims wherein a gap structure (30) is arranged in said conductive layer (26), wherein said gap structure (30) differs between at least two of said connectors (22).

16. An NMR probe head comprising
a coil (2) of any of the preceding claims,
a base (1) having a housing (8) and an electrical interface (5), and
a tube (3) extending between said housing (8) and said coil (2).

17. The NMR probe head of claim 16 comprising an actuator (11) mechanically connected to said tunable reactance element (23a, 40, 42).

18. The NMR probe head of claim 17 comprising several of said tunable reactance elements (23a, 40, 42) and several of said actuators (11), wherein each actuator (11) is connected to one tunable reactance element (23a, 40, 42).

19. A method for reducing an asymmetry in an NMR probe head of any of the claims 16 to 18 or an NMR coil of any of the claims 1 to 15 comprising the steps of
detecting an asymmetry of the coil, and
adjusting the at least one tunable reactance to reduce the asymmetry.

## Patentansprüche

1. Eine NMR-Spule umfassend
einen ersten und einen zweiten leitenden Ring (20a, 20b), die in einem Abstand zueinander angeordnet sind,
eine Vielzahl von voneinander beabstandeten Konnektoren (22), die sich zwischen dem ersten und dem zweiten leitenden Ring (20a, 20b) erstrecken, wobei jedes von mindestens mehreren der Konnektoren (22) mindestens ein Reaktanzelement (23a, 23b, 40, 42) umfasst,
wobei mindestens eines der Reaktanzelemente (23a, 23b, 40, 42) ein abstimmbares Reaktanzelement (23a) mit einer Reaktanz ist, die unabhängig von einer Reaktanz mindestens eines anderen Reaktanzelements (23a, 23b, 40, 42) abstimmbar ist, und
wobei mindestens ein Teil der Reaktanzelemente (23a, 23b) ein kapazitives Element umfasst, das
eine erste Elektrode (26a, 26b) hat, die elektrisch mit dem ersten leitenden Ring (20a) verbunden ist, und
eine zweite Elektrode (26b, 26c) hat, die elektrisch mit dem zweiten leitenden Ring (20b) verbunden und von der ersten Elektrode (26a, 26b) elektrisch isoliert ist,
**dadurch gekennzeichnet, dass**
jeder der Konnektoren (22) einen isolierenden Stab (25) und mindestens eine elektrisch leitende Schicht (26) umfasst, die auf oder in dem Stab (25) angeordnet ist, wobei die erste und zweite Elektrode (23a, 23b, 23c) durch die leitende Schicht (26) gebildete interdigitale Elektroden (35a - 35d) sind, und
wobei das kapazitive Element (23a) zusätzlich zur ersten Elektrode (26a) und zur zweiten Elektrode (26b) eine dritte Elektrode (32) umfasst, die von der ersten und der zweiten Elektrode (26a, 26b) elektrisch isoliert ist, wobei die dritte Elektrode (32) in Bezug auf die erste und die zweite Elektrode (26a, 26b) beweglich ist.

2. Die NMR-Spule nach Anspruch 1, umfassend mehrere unabhängig voneinander abstimmbare Reaktanzelemente (23a).

3. Die NMR-Spule nach einem der vorangehenden Ansprüche, wobei jeder Konnektor (22) mindestens ein abstimmbares Reaktanzelement (23a) umfasst.

4. Die NMR-Spule nach Anspruch 3, wobei die abstimmbaren Reaktanzelemente (23a) unabhängig voneinander abstimmbar sind.

5. Die NMR-Spule nach einem der vorangehenden Ansprüche, wobei die Elektroden (26a, 26b, 26c) eine magnetische Suszeptibilität von Null aufweisen.

6. Die NMR-Spule nach einem der vorangehenden Ansprüche, wobei die mindestens eine elektrisch leitende Schicht (26) auf einer Oberfläche des Stabes (25) angeordnet ist.

7. Die NMR-Spule nach einem der vorangehenden Ansprüche, wobei der Stab (25) aus einem keramischen Material besteht, insbesondere aus einem keramischen Material mit Aluminiumoxid.

8. Die NMR-Spule nach einem der vorangehenden Ansprüche, wobei die leitende Schicht (26) eine magnetische Suszeptibilität von Null aufweist, und wobei insbesondere die leitende Schicht (26) Rhodium und Kupfer umfasst.

9. Die NMR-Spule nach einem der vorangehenden Ansprüche, wobei der Stab (25) eine zylindrische Oberfläche aufweist und wobei sich die leitfähige Schicht (26) zumindest über einen Teil einer Länge des Stabs (25) um den gesamten Umfang der zylindrischen Oberfläche herum erstreckt.

10. Die NMR-Spule nach einem der vorangehenden Ansprüche, wobei die erste und die zweite Elektrode (26a, 26b, 26c) durch Abschnitte der leitfähigen Schicht (26) gebildet sind.

11. Die NMR-Spule nach Anspruch 10, wobei der Stab (25) einen Hohlraum (33) aufweist und wobei die dritte Elektrode (32) im Hohlraum (33) angeordnet ist.

12. Die NMR-Spule nach Anspruch 11, wobei die dritte Elektrode (32) beweglich im Hohlraum (33) angeordnet ist.

13. Die NMR-Spule nach einem der Ansprüche 11 oder 12, wobei sich der Hohlraum (33) über die gesamte Länge des Stabes (25) erstreckt.

14. Die NMR-Spule nach einem der vorangehenden Ansprüche, wobei die leitende Schicht (26) mindestens eine Induktionsspule (40) und/oder mindestens einen Mäanderinduktor (42) bildet.

15. Die NMR-Spule nach einem der vorangehenden Ansprüche, wobei in der leitenden Schicht (26) eine Spaltstruktur (30) angeordnet ist, wobei sich die Spaltstruktur (30) zwischen mindestens zwei der Anschlüsse (22) unterscheidet.

16. Ein NMR-Sondenkopf, umfassend
eine Spule (2) nach einem der vorangehenden Ansprüche,
eine Basis (1) mit einem Gehäuse (8) und einer elektrischen Schnittstelle (5), und
ein Rohr (3), das sich zwischen dem Gehäuse (8) und der Spule (2) erstreckt.

17. Der NMR-Sondenkopf nach Anspruch 16, umfassend einen Aktor (11), der mechanisch mit dem abstimmbaren Reaktanzelement (23a, 40, 42) verbunden ist.

18. Der NMR-Sondenkopf nach Anspruch 17, umfassend mehrere der abstimmbaren Reaktanzelemente (23a, 40, 42) und mehrere der Aktoren (11), wobei jeder Aktor (11) mit einem abstimmbaren Reaktanzelement (23a, 40, 42) verbunden ist.

19. Ein Verfahren zur Reduzierung einer Asymmetrie in einem NMR-Sondenkopf nach einem der Ansprüche 16 bis 18 oder einer NMR-Spule nach einem der Ansprüche 1 bis 15, umfassend die Schritte
Erfassen einer Asymmetrie der Spule, und Einstellen der mindestens einen abstimmbaren Reaktanz, um die Asymmetrie zu reduzieren.

## Revendications

1. Une bobine de RMN comprenant
un premier et un second anneau conducteur (20a, 20b) espacés l'un de l'autre,
une pluralité de connecteurs espacés (22) s'étendant entre lesdits premier et deuxième anneaux conducteurs (20a, 20b), chacun d'au moins une pluralité desdits connecteurs (22) comprenant au moins un élément de réactance (23a, 23b, 40, 42),
dans laquelle au moins un des éléments de réactance (23a, 23b, 40, 42) est un élément de réactance ajustable (23a) ayant une réactance qui est ajustable indépendamment d'une réactance d'au moins un autre élément de réactance (23a, 23b, 40, 42), et
dans laquelle au moins une partie des éléments de réactance (23a, 23b) comprend un élément capacitif ayant
une première électrode (26a, 26b) connectée électriquement au premier anneau conducteur (20a), et
une deuxième électrode (26b, 26c) connectée électriquement au deuxième anneau conducteur (20b) et isolée électriquement de la première électrode (26a, 26b),
**caractérisé en ce que**
chacun desdits connecteurs (22) comprend une tige isolante (25) et au moins une couche électriquement conductrice (26) disposée sur ou dans ladite tige (25), ladite première et seconde électrode (23a, 23b, 23c) étant des électrodes interdigitales (35a - 35d) formées par ladite couche conductrice (26), et
l'élément capacitif (23a) comprend, en plus de la première électrode (26a) et de la deuxième électrode (26b), une troisième électrode (32) isolée électriquement de la première et la deuxième électrode (26a, 26b), la troisième électrode (32) étant mobile par rapport à la première et la deuxième électrode (26a,
26b) .

2. La bobine RMN selon la revendication 1, comprenant une pluralité d'éléments de réactance indépendamment ajustables (23a).

3. La bobine RMN selon l'une des revendications précédentes, dans laquelle chaque connecteur (22) comprend au moins un élément de réactance ajustable (23a) .

4. La bobine RMN selon la revendication 3, dans laquelle les éléments de réactance ajustables (23a) sont ajustables indépendamment.

5. La bobine RMN selon l'une des revendications précédentes, dans laquelle les électrodes (26a, 26b, 26c) ont une susceptibilité magnétique nulle.

6. La bobine RMN selon l'une des revendications précédentes, dans laquelle la au moins une couche électriquement conductrice (26) est disposée sur une surface de la tige (25).

7. La bobine RMN selon l'une des revendications précédentes, dans laquelle la tige (25) est réalisée en matériau céramique, notamment en matériau céramique comprenant de l'alumine.

8. La bobine RMN selon l'une des revendications précédentes, dans laquelle la couche conductrice (26) présente une susceptibilité magnétique nulle, et en particulier dans laquelle la couche conductrice (26) comprend du rhodium et du cuivre.

9. La bobine RMN selon l'une des revendications précédentes, dans laquelle la tige (25) a une surface cylindrique et dans laquelle la couche conductrice (26) s'étend autour de la circonférence entière de la surface cylindrique sur au moins une partie d'une longueur de la tige (25).

10. La bobine RMN selon l'une des revendications précédentes, dans laquelle la première et la deuxième électrode (26a, 26b, 26c) sont formées par des parties de la couche conductrice (26).

11. La bobine RMN selon la revendication 10, dans laquelle la tige (25) comprend une cavité (33) et dans laquelle la troisième électrode (32) est disposée dans la cavité (33).

12. La bobine RMN selon la revendication 11, dans laquelle la troisième électrode (32) est disposée de manière mobile dans la cavité (33).

13. La bobine RMN selon l'une des revendications 11 ou 12, dans laquelle la cavité (33) s'étend sur toute la longueur de la tige (25).

14. La bobine RMN selon l'une des revendications précédentes, dans laquelle la couche conductrice (26) forme au moins une bobine d'induction (40) et/ou au moins une inductance à méandre (42).

15. La bobine RMN selon l'une des revendications précédentes, dans laquelle une structure d'espacement (30) est disposée dans la couche conductrice (26), la structure d'espacement (30) étant différente entre au moins deux des connecteurs (22).

16. Une tête de sonde RMN comprenant
une bobine (2) selon l'une des revendications précédentes,
une base (1) comprenant un boîtier (8) et une interface électrique (5), et
un tube (3) s'étendant entre le boîtier (8) et la bobine (2).

17. La tête de sonde RMN selon la revendication 16, comprenant un actionneur (11) relié mécaniquement à l'élément de réactance ajustable (23a, 40, 42) .

18. La tête de sonde RMN selon la revendication 17, comprenant une pluralité d'éléments de réactance ajustables (23a, 40, 42) et une pluralité d'actionneurs (11), dans laquelle chaque actionneur (11) est connecté à un élément de réactance ajustable (23a, 40, 42).

19. Un procédé de réduction d'une asymétrie dans une tête de sonde RMN selon l'une des revendications 16 à 18 ou une bobine RMN selon l'une des revendications 1 à 15, comprenant les étapes suivantes
détecter une asymétrie de la bobine, et ajuster l'au moins une réactance ajustable pour réduire l'asymétrie.
